# EUROPEAN PATENT SPECIFICATION

(11) **EP 3 706 276 B1**
(45) Date of publication and mention of the grant of the patent: **20.12.2023**
(21) Application number: 19763364.7
(22) Date of filing: 21.02.2019
(51) Int. Cl.: H02J 3/36, H02M 1/32, G01R 31/26, G01R 31/327

(54) **BYPASS THYRISTOR VALVE GROUP INSPECTION METHOD AND CONTROL DEVICE**
VERFAHREN UND VORRICHTUNG ZUR STEUERUNG DER VENTILGRUPPE EINES BYPASS-THYRISTORS
PROCÉDÉ D'INSPECTION ET DISPOSITIF DE COMMANDE DE GROUPE DE VALVES À THYRISTORS DE DÉRIVATION

(30) Priority: 05.03.2018 CN 201810178405
(43) Date of publication of application: 09.09.2020
(73) Proprietor: NR Electric Co., Ltd., Nanjing, Jiangsu 211102 (CN); NR Engineering Co., Ltd., Nanjing, Jiangsu 211102 (CN)
(72) Inventor: LU, Dongbin, Nanjing, Jiangsu 211102 (CN); HUANG, Hua, Nanjing, Jiangsu 211102 (CN); PAN, Weiming, Nanjing, Jiangsu 211102 (CN); GAO, Shengfu, Nanjing, Jiangsu 211102 (CN); LIU, Lei, Nanjing, Jiangsu 211102 (CN); YANG, Fan, Nanjing, Jiangsu 211102 (CN)
(74) Representative: Grünecker Patent- und Rechtsanwälte PartG mbB
(86) International application number: PCT/CN2019/075672
(87) International publication number: WO 2019/170002

(56) References cited:
- EP-A1- 0 283 268
- EP-A1- 3 068 008
- CN-A- 102 005 906
- CN-A- 102 055 307
- CN-A- 102 130 612
- CN-A- 103 645 399
- CN-A- 106 505 606
- CN-A- 106 787 876
- CN-A- 107 546 962
- CN-A- 108 258 715
- JP-A- 2012 010 542
- US-A- 4 641 231
- US-A1- 2015 309 108
- US-A1- 2016 036 314
- US-A1- 2017 025 856

## Description

### Technical Field

The present invention relates to the field of High Voltage Direct Current (HVDC) transmission employing Voltage-Source Converters (VSCs) and HVDC transmission employing Line Commutated Converters (LCCs), and in particular, to a bypass thyristor valve group inspection method and control apparatus.

### Background

Voltage Source Converter based High Voltage Direct Current Transmission (VSC-HVDC) has the advantages that the controllability is high, a passive system can be accessed, and no reactive power compensation apparatus is needed, and has the disadvantages that the converter has large switching loss, and when an alternating current (AC) system or converter on the inverter side has a fault, especially when a valve region between the converter and a converter transformer has a fault, a large voltage and current impact can be generated to the converter, and more seriously, the converter may even be damaged. In order to avoid the impact of DC voltage and DC current caused by a rectifier side, generally, a lightning arrester is connected in parallel to a bridge arm of the voltage source converter, which requires a large capacity, and thus it is difficult for engineering implementation. The patent with the application No.: CN201510010158.1 and entitled "Hybrid HVDC Converter and HVDC Apparatus" provides a hybrid HVDC converter, in which a voltage source type valve group is connected to an inductor and then to a bypass switch in parallel, and the bypass switch is a power electronic switch. According to this solution, the effect of protecting the converter is better, but the power electronic switch needs to be monitored, so that normal turn-on can be ensured under serious fault conditions, thereby protecting the voltage source converter.

US 2015/309108 A1 discloses a thyristor circuit comprising at least one series circuit in which two or more thyristors are connected in series. Each thyristor is parallel-connected to an RC member. A control device can energize the thyristors individually and independently of each other by a control signal, so that each thyristor can be individually switched into its conducting condition. During a test sequence, the thyristors are switched successively into their conducting condition, wherein, in a series circuit and/or in the thyristor circuit, respectively only one thyristor is in its conducting condition.

It is the object of the present invention to provide an improved bypass thyristor valve group inspection method and control device.

This object is solved by the subject matter of the independent claims.

Embodiments are defined in the dependent claims.

An objective of the present invention is to provide a bypass thyristor valve group inspection method for inspecting sub-modules, connected in parallel at two ends of a DC side of a voltage source converter, in a bypass thyristor valve group, so as to ensure that the bypass thyristor valve group can be normally conducted under serious fault conditions. Also provided is a bypass thyristor valve group inspection control apparatus for controlling the bypass thyristor valve group to implement the foregoing inspection method.

In order to achieve the foregoing objective, the present invention provides a method according to claim 1.

In the foregoing solution, the bypass thyristor valve group includes only one bridge arm which is formed by connecting a plurality of thyristors in series, and includes a corresponding control protection circuit. The bypass thyristor valve group is configured to bypass a voltage source converter connected in parallel thereto or a voltage source converter on a parallel branch thereof. The principle of dividing the bypass thyristor valve group into N sub-modules is: when a single sub-module is turned on, the remaining sub-modules which are not turned on can bear a forward voltage during normal operation.

The sequentially triggering the sub-modules according to a certain time period refers to: triggering the sub-modules in sequence or triggering the sub-modules according to a certain probability algorithm, and ensuring that each sub-module is triggered at least once in the certain time period, where the certain time period is on the order of second, or minute, or hour, or day, or month, or year.

The detecting whether the sub-modules are capable of operating normally or not is determined based on detecting whether the sub-modules are from an off-state to an on-state, or in an on-state, or from an on-state to an off-state.

The normal operation of the sub-modules refers to the fact that all thyristors in the sub-modules can be normally turned on, or a certain redundancy is set for the sub-modules; if it is detected that the number of thyristors that cannot be turned on in the sub-modules is less than the redundancy, the inspection is continued; and if the bypass thyristor valve group is required to put into operation, the thyristors that cannot be turned on implement current flowing by means of protective trigger or breakdown.

The voltage source converter is any one or more of: a two-level converter, a diode-clamped multilevel converter, a Modular Multilevel Converter (MMC), a Hybrid Multilevel Converter (HMC), a two-level cascaded converter CSL, or a stacked two-level converter CTL, and consists of a switchable fully-controlled power semiconductor that can be turned off. The fully-controlled power semiconductor that can be turned off is any one or more of: an Insulated Gate Bipolar Transistor (IGBT), an Integrated Gate Commutated Thyristor (IGCT), a Gate-Turn-Off Thyristor (GTO), a Power MOSFET, an Injection Enhanced Gate Transistor (IEGT), a Gate Commutated Thyristor (GCT), or a Silicon Carbide Enhanced Junction Field Effect Transistor (SiC-JFET).

The present invention further provides a bypass thyristor valve group inspection control apparatus according to claim 7.

The bypass thyristor valve group includes only one bridge arm which is formed by connecting a plurality of thyristors in series, and includes a corresponding control protection circuit. The bypass thyristor valve group is configured to bypass a voltage source converter connected in parallel thereto or a voltage source converter on a parallel branch thereof. The principle of dividing the bypass thyristor valve group into N sub-modules is: when a single sub-module is turned on, the remaining sub-modules which are not turned on can bear a forward voltage during normal operation.

The sequentially sending the control pulse to the valve-based electronic units of different sub-modules of the bypass thyristor valve group according to a certain time period refers to: triggering the sub-modules in sequence or triggering the sub-modules according to a certain probability algorithm, and ensuring that each sub-module is triggered at least once in the certain time period, where the certain time period is on the order of second, or minute, or hour, or day, or month, or year.

The fact that the valve group control unit receives the sub-module turn-on signal of the valve-based electronic unit is that all thyristors in the sub-modules are turned on, or a certain redundancy is set for the sub-modules, and the thyristors that do not exceed the redundancy in the sub-modules are turned on. The fact that the valve group control unit does not receive the sub-module turn-on signal of the valve-based electronic unit is that any one or more thyristors in the sub-modules are not turned on, or the thyristors that exceed the redundancy in the sub-module are not turned on.

The thyristor turn-on signal sent to the valve-based electronic unit by the thyristor control unit refers to that the thyristor-born forward voltage signal disappears, or current flows through the thyristor, or the thyristor-born forward voltage signal reappears. The control circuit of the thyristor control unit has a protective trigger function, and if the thyristor does not receive the trigger pulse of the valve-based electronic unit, before being broken down, the thyristor is subjected to protective trigger.

The present invention has the following beneficial effects: provided are a bypass thyristor valve group inspection method and control apparatus for detecting the state of each sub-module of a bypass thyristor valve group when the bypass thyristor valve group is not turned on, and sending an alarm signal if the state of the sub-module is abnormal, and the problem of thyristor performance monitoring under the condition that the bypass thyristor valve group does not operate for a long time is effectively solved.

### Brief Description of the Drawings

FIG. 1 illustrates a hybrid HVDC transmission circuit structure with a sending end based on a line commutated converter and a receiving end based on a voltage source converter;
FIG. 2 illustrates a hybrid HVDC transmission circuit structure with a sending end based on two line commutated converters and a receiving end based on a line commutated converter and a voltage source converter;
FIG. 3 is a bypass thyristor valve group inspection method according to the present disclosure:
FIG. 4 is a bypass thyristor valve group inspection control apparatus according to the present disclosure; and
FIG. 5 is a thyristor control unit circuit as used in the present invention.

### Detailed Description

Embodiments of the present invention are described with reference to the following drawings, and the same components are numbered with the same reference numerals.

For the VSC-HVDC transmission system, when the AC system or converter on the inverter side has a fault, especially when a valve region between the converter and a converter transformer has a fault, a large voltage and current impact can be generated to the converter, and more seriously, the converter may even be damaged. In order to avoid the impact of DC voltage and DC current caused by a rectifier side, a bypass power electronic switch, e.g., a bypass thyristor valve group is connected in parallel to two ends of a DC side of the voltage source converter. The bypass thyristor valve group connected in parallel to two ends of the DC side of the voltage source converter is turned on for discharging only under serious fault conditions, and is not turned on during normal operation. Therefore, in order to ensure that the bypass thyristor valve group is always in a normal state, the bypass thyristor valve group is detected according to a certain time period, thereby ensuring normal turn-on under serious fault conditions, and protecting the voltage source converter.

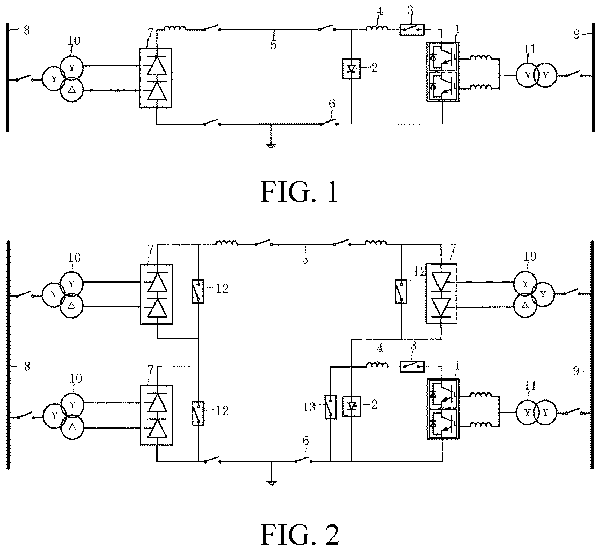

FIG. 1 illustrates a hybrid HVDC transmission embodiment with a sending end based on a line commutated converter and a receiving end based on a voltage source converter. A line commutated converter 7 on the rectifier side converts the AC power of an AC system 8 into DC power via a converter transformer 10, and the DC power is sent to a voltage source converter 1 on the inverter side through a current limiting reactor 4 via a DC line 5, and is converted into AC power via a main transformer 11 and then sent to an AC system 9. The line commutated converter 7 is a six-pulse bridge circuit or a twelve-pulse bridge circuit, which consists of semi-controlled power semiconductors which cannot be turned off, generally, thyristors which cannot be turned off. The voltage source converter 1 is a two-level converter, a diode-clamped multilevel converter, an MMC, an HMC, a CSL, or a CTL, and consists of a fully-controlled power semiconductor that can be turned off, such as an IGBT or an IGCT.

When a minor fault occurs in the AC system 9, and the voltage source converter 1 does not need to block, for example, a single-phase AC ground fault, after detecting overvoltage or overcurrent, the line commutated converter 7 on the rectifier side adjusts a trigger angle to inhibit DC from increasing, and the overvoltage or overcurrent can be eliminated through the control capability of the rectifier side.

When a serious fault occurs in the AC system 9, and the voltage source converter 2 needs to block, for example, a three-phase AC short-circuit fault, the power of the voltage source converter 1 on the inverter side cannot be normally sent out, and the line commutated converter 7 on the rectifier side continues to charge the voltage source converter 1 on the inverter side due to the relatively slow angle adjustment of the line commutated converter on the rectifier side, which causes serious overvoltage and overcurrent to the voltage source converter 1 on the inverter side. In order to avoid damaging the voltage source converter 1 on the inverter side, after it is detected that a serious fault occurs in the AC system 9 or the voltage or current of the converter exceeds a threshold, a bypass thyristor valve group 2 is triggered to turn on, a connection switch 3 between the bypass thyristor valve group 2 and the voltage source converter 1 is turned off, and the current of the bypass thyristor valve group 2 is controlled to zero to be off by retard of the line commutated converter 7 on the rectifier side; after the fault disappears, the connection switch 3 between the thyristor valve group 2 and the voltage source converter 1 is turned on, and the voltage source converter 1 is connected. In order to ensure that the bypass thyristor valve group 2 is quickly and reliably turned off, a switch 6 on a neutral line of a main loop can be turned off when the DC current is low or zero, and the switch 6 is then turned on after the current is zero.

FIG. 2 illustrates a hybrid HVDC transmission embodiment with a sending end based on a line commutated converter series structure and a receiving end based on a line commutated converter and a voltage source converter which are connected in series. The line commutated converter 7 on the rectifier side converts the AC power of the AC system 8 into DC power via the converter transformer 10, and the DC power is sent to a line commutated converter 7 on the inverter side and the voltage source converter 1 via the DC line 5, and is converted into AC power via the main transformer 11 and then sent to the AC system 9. On the inverter side, a cathode of the line commutated converter 7 is connected to an anode of the voltage source converter 1.

When a minor fault occurs in the AC system 9, and the voltage source converter 1 does not need to block, for example, a single-phase AC ground fault, the line commutated converter 7 on the inverter side has a fault during commutation, and the voltage source converter 1 implements fault ride-through, and after receiving fault information sent by the inverter side, the line commutated converter on the rectifier side adjusts the trigger angle to inhibit the DC from increasing, and the overvoltage or overcurrent can be eliminated through the control capability of the rectifier side.

When a serious fault occurs in the AC system 9, and the voltage source converter 1 needs to block, if it is a transient self-recovery fault, for example, a three-phase AC transient short-circuit fault, the power of the voltage source converter 1 on the inverter side cannot be normally sent out transiently, the line commutated converter 7 on the inverter side cannot send the power out due to the relatively slow angle adjustment of the line commutated converter 7 on the rectifier side, and the line commutated converter 7 on the rectifier side only charges the voltage source converter 1 on the inverter side, which causes a more serious overvoltage and overcurrent phenomenon to the voltage source converter 1 on the inverter side. In order to avoid damaging the voltage source converter 1 on the inverter side, after it is detected that the voltage or current of the converter exceeds a threshold due to the fact that a serious fault occurs in the AC system, the bypass thyristor valve group 2 is triggered to turn on, the connection switch 3 between the bypass thyristor valve group 2 and the voltage source converter 1 is turned off, and the current of the bypass thyristor valve group 2 is controlled to zero to be off by retard of the line commutated converter 7 on the rectifier side; after the fault disappears, the connection switch 3 between the thyristor valve group 2 and the voltage source converter 1 is turned on, and the voltage source converter 1 is connected. In order to ensure that the bypass thyristor valve group 2 is quickly and reliably turned off, the switch 6 on the neutral line of the main circuit can be turned off when the DC current is low or zero, and the switch 6 is then turned on after the current is zero.

When a serious fault occurs in the voltage source converter 1, and the voltage source converter 1 needs to block, if it is not a transient self-recovery fault, for example, a fault of the converter itself, the voltage source converter 1 needs to block, the bypass thyristor valve group 2 is triggered to turn on, and the connection switch 3 between the bypass thyristor valve group 2 and the voltage source converter 1 is turned off. In order to ensure that the line commutated converter 7 continues to operate, current continue to flow through the bypass thyristor valve group 2, or a bypass switch 13 is turned on to provide a current path. When a serious fault occurs in the AC system 9 or the line commutated converter 7 on the inverter side, and the line commutated converter 7 needs to block, a bypass pair of the line commutated converter 7 is triggered to turn on, and a bypass switch 12 is turned on to provide a current path for the voltage source converter 1.

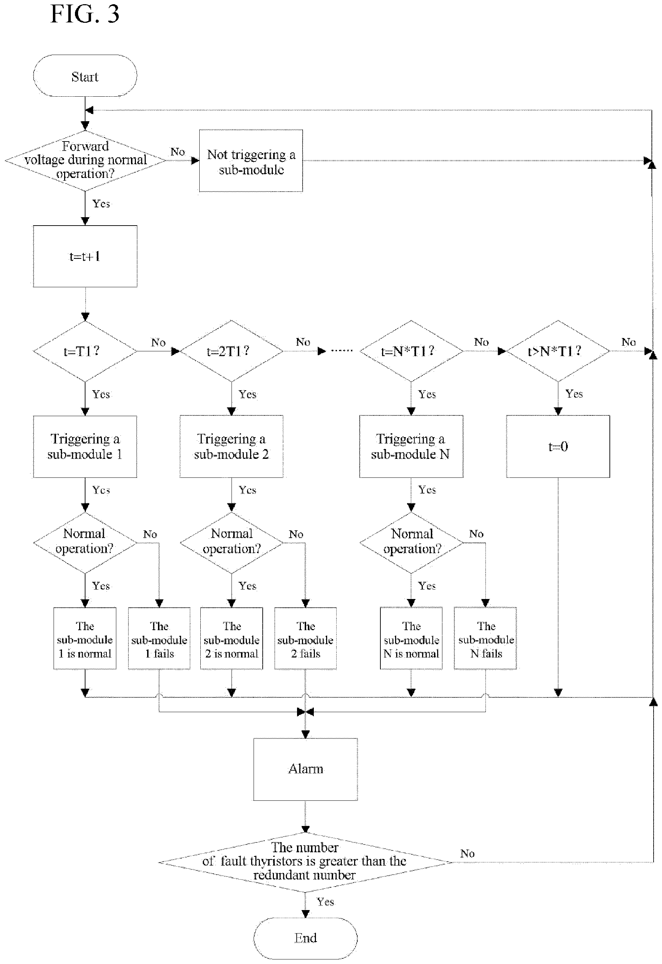

FIG. 3 is a bypass thyristor valve group inspection method according to the present disclosure, including: inspecting the voltage source converter 1 or the bypass thyristor valve group 2 connected in parallel to a series branch of the voltage source converter 1 in FIGS. 1 and 2, and dividing the bypass thyristor valve group into N sub-modules, where each sub-module is formed by connecting one or more thyristors in series, and when a single sub-module is turned on, the remaining sub-modules can bear a forward voltage during normal operation. A program is initialized, and a counter t=0, if the bypass thyristor valve group bears the forward voltage during normal operation, the counter starts to increase from t, if t is increased to T1, then a sub-module 1 is triggered, if the sub-module 1 is normally turned on, the remaining sub-modules continue to be inspected, if the sub-module 1 has a fault, an alarm signal indicating that the sub-module 1 has a fault is sent, and the inspection is stopped; if t is increased to 2*T1, a sub-module 2 is triggered, if the sub-module 2 is normally turned on, the remaining sub-modules continue to be inspected, if the sub-module 2 has a fault, an alarm signal indicating that the sub-module 2 has a fault is sent, and the inspection is stopped; if there is no fault, t continues to increase, if t is increased to N*T1, a sub-module N is triggered, if the sub-module N is normally turned on, the remaining sub-modules continue to be inspected, if the sub-module N has a fault, an alarm signal indicating that the sub-module N has a fault is sent, and the inspection is stopped; and if t>N*T1, t=0, and the sub-module 1 is re-inspected. If the bypass thyristor valve group bears a lower forward voltage, the sub-module is not triggered to be turned on, and a low voltage alarm signal is sent. If the bypass thyristor valve group bears a higher forward voltage, which is lower than a fixed value of a bypass thyristor valve group provided, the sub-module is not triggered to be turned on, and a high voltage alarm signal is sent; if the voltage is higher than the fixed value of the bypass thyristor valve group provided, all sub-modules of the bypass thyristor valve group are triggered; and if a command that the bypass thyristor valve group is provided to the voltage source converter is received, the inspection is stopped, and all sub-modules of the bypass thyristor valve group are triggered. The normal turn-on of the sub-module refers to the fact that all thyristors in the sub-module are turned on, or a certain redundancy is set for the sub-module; when it is detected that the number of thyristors that cannot be turned on in the sub-module is less than the redundancy, the inspection is continued; and when the bypass thyristor valve group is required to put into operation, the thyristors that cannot be turned on implement current flowing by means of protective trigger or breakdown.

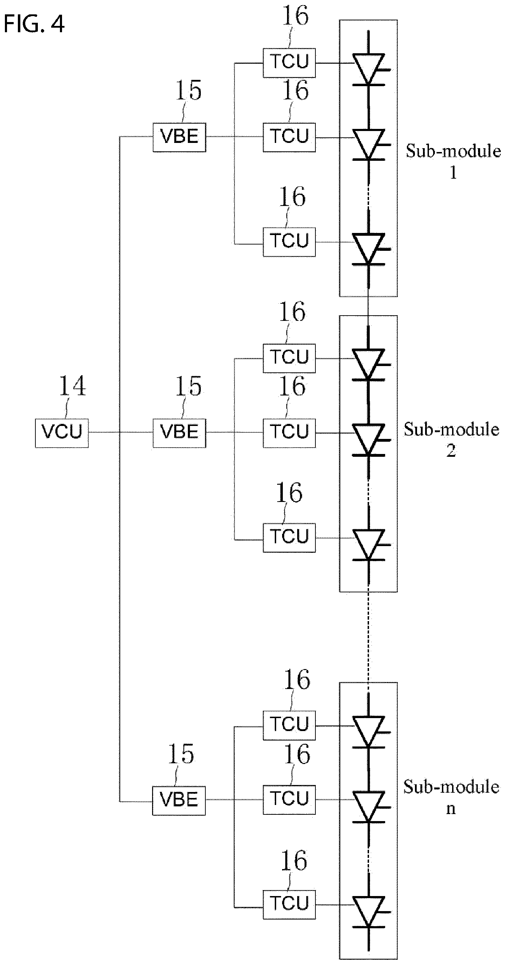

FIG. 4 is a bypass thyristor valve group inspection control apparatus according to the present disclosure, including: a valve group control unit VCU 14, a valve-based electronic unit VBE 15, and a thyristor control unit TCU 16, and configured to inspect the bypass thyristor valve group 2 connected in parallel to the voltage source converter 1 in FIGS. 1 and 2. The bypass thyristor valve group is divided into a sub-module 1, a sub-module 2, ..., and a sub-module N, and each sub-module is formed by connecting one or more thyristors in series. When a single sub-module is turned on, the remaining sub-modules which are not turned on can bear a forward voltage during normal operation.

The valve group control unit VCU 14 is configured to: detect a forward voltage born by the bypass thyristor valve group during normal operation; send a control pulse CP to the valve-based electronic units VBE 15 of the sub-module 1, the sub-module 2, ..., and the sub-module N of the bypass thyristor valve group according to a certain time period; receive a sub-module turn-on signal of the valve-based electronic unit; and if no sub-module turn-on signal of the valve-based electronic units is received, send an alarm signal.

The valve-based electronic unit VBE 15 is configured to receive the control pulse CP of the valve group control unit VCU 14and a thyristor-born forward voltage signal IP and a thyristor turn-on signal CS of the thyristor control unit TCU 16, send a trigger pulse FP to the thyristor control unit TCU 16, and send the sub-module turn-on signal to the valve group control unit. The sub-module turn-on signal indicates that all thyristors in the sub-module are turned on.

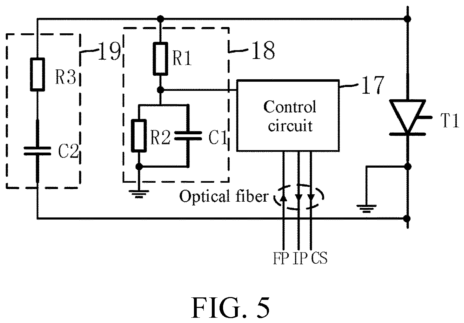

FIG. 5 illustrates a circuit structure diagram of the thyristor control unit TCU 16, including a control circuit 17, a powering loop 18, and a resistance-capacitance discharge loop 19. The control circuit 17 is configured to receive the trigger pulse FP of the valve-based electronic unit VBE 15, send the thyristor-born forward voltage signal IP and the thyristor turn-on signal CS to the valve-based electronic unit VBE 15. The powering loop 18 at least includes two static voltage-sharing resistors R1, R2 and an energy storage capacitor C1, and before the thyristor is turned on, enough energy can be obtained to ensure the normal turn-on of the thyristor. The resistance-capacitance discharge loop 19 at least includes a resistor R3 and a capacitor C2 which are connected in series, and after the thyristor T1 is turned on, enough energy can be obtained to ensure the normal turn-on of the thyristor.

Optionally, the thyristor turn-on signal CS is indirectly determined by means of the thyristor-born forward voltage signal IP, and when the valve group control unit VCU 14 sends the control pulse CP, the thyristor control unit TCU 16 is detected to have the thyristor-born forward voltage signal IP in a short time, which proves the process that the thyristor T1 bears a forward voltage from on to off once.

The control circuit 17 of the thyristor control unit TCU 16 has a protective trigger function, and when the thyristor T1 does not receive the trigger pulse of the valve-based electronic unit, the thyristor T1 is subjected to protective trigger before being broken down.

The foregoing embodiments are for only describing the technical idea of the present invention, and are not intended to limit the scope of protection of the preset invention. Any modification made based on the technical solutions according to the technical idea of the present invention shall fall within the scope of protection of the present invention as defined by the appended claims.

## Claims

1. A bypass thyristor valve group (2) inspection method for inspecting sub-modules in a bypass thyristor valve group, comprising:
dividing, by valve group control unit (14), the bypass thyristor valve group into N sub-modules, wherein N is greater than or equal to 2, N is a natural number, and each sub-module is formed by one thyristor or by connecting two or more thyristors in series;
under the condition that the bypass thyristor valve group bears a forward voltage during normal operation, sequentially triggering, in conjunction with a valve-based electronic unit (15), the sub-modules according to a certain time period; and
detecting whether the sub-modules are capable of operating normally or not, and if not, sending an alarm signal,
wherein the bypass thyristor valve group further comprises a thyristor control unit (16), and the inspection method further comprises:
receiving, by the thyristor control unit, a trigger pulse of the valve-based electronic unit; sending, by the thyristor control unit, the thyristor-born forward voltage signal to the valve-based electronic unit; and
sending, by the thyristor control unit, the thyristor turn-on signal to the valve-based electronic unit, wherein the thyristor control unit further comprises a powering loop (18) and a resistance-capacitance discharge loop (19); the powering loop at least comprises two static voltage-sharing resistors and an energy storage capacitor, and before the thyristor is turned on, enough energy can be obtained to ensure the normal turn-on of the thyristor; and the resistance-capacitance discharge loop at least comprises a resistor and a capacitor which are connected in series, and after the thyristor is turned on, enough energy can be obtained to ensure the normal conduction of the thyristor.

2. The bypass thyristor valve group inspection method according to claim 1, wherein the bypass thyristor valve group comprises only one bridge arm which is formed by connecting a plurality of thyristors in series, and comprises a corresponding control protection circuit; and the bypass thyristor valve group is configured to bypass a voltage source converter (1) connected in parallel thereto or a voltage source converter on a parallel branch thereof.

3. The bypass thyristor valve group inspection method according to claim 1, wherein the principle of dividing the bypass thyristor valve group into N sub-modules is: when a single sub-module is turned on, the remaining sub-modules which are not turned on can bear the forward voltage during normal operation.

4. The bypass thyristor valve group inspection method according to claim 1, wherein the sequentially triggering the sub-modules according to a certain time period refers to: triggering the sub-modules in sequence or triggering the sub-modules according to a certain probability algorithm, and ensuring that each sub-module is triggered at least once in the certain time period, wherein the certain time period is on the order of second, or minute, or hour, or day, or month, or year.

5. The bypass thyristor valve group inspection method according to claim 1, wherein the detecting whether the sub-modules are capable of operating normally or not is determined based on detecting whether the sub-modules are from an off-state to an on-state, or in an on-state, or from an on-state to an off-state.

6. The bypass thyristor valve group inspection method according to claim 1, wherein the normal operation of the sub-modules means that all thyristors in the sub-modules can be normally turned on, or a certain redundancy is set for the sub-modules; if it is detected that the number of thyristors that cannot be turned on in the sub-modules is less than the redundancy, the inspection is continued; and if the bypass thyristor valve group is required to put into operation, the thyristors that cannot be turned on provide current flow by means of protective trigger or breakdown.

7. A bypass thyristor valve group (2) inspection control apparatus for inspecting sub-modules in a bypass thyristor valve group, comprising a valve group control unit (14), a valve-based electronic unit (15), and a thyristor control unit (16), wherein
the valve group control unit is configured to: divide the bypass thyristor valve group into N sub-modules, wherein N is greater than or equal to 2, N is a natural number, and each sub-module is formed by one thyristor or by connecting two or more thyristors in series; detect a forward voltage born by the bypass thyristor valve group during normal operation; sequentially send a control pulse to the valve-based electronic units of different sub-modules of the bypass thyristor valve group according to a certain time period; receive sub-module turn-on signals of the valve-based electronic units; and if no sub-module turn-on signal of the valve-based electronic units is received, send an alarm signal;
the valve-based electronic unit is configured to receive the control pulse of the valve group control unit and a thyristor-born forward voltage signal of the thyristor control unit, receive a thyristor turn-on signal of the thyristor control unit, send a trigger pulse to the thyristor control unit, and send the sub-module turn-on signal to the valve group control unit; and
the thyristor control unit comprises a control circuit (17), configured to receive the trigger pulse of the valve-based electronic unit, send the thyristor-born forward voltage signal to the valve-based electronic unit, and send the thyristor turn-on signal to the valve-based electronic unit, wherein the thyristor control unit further comprises a powering loop (18) and a resistance-capacitance discharge loop (19), the powering loop at least comprises two static voltage-sharing resistors and an energy storage capacitor, and before the thyristor is turned on, enough energy can be obtained to ensure the normal turn-on of the thyristor, and the resistance-capacitance discharge loop at least comprises a resistor and a capacitor which are connected in series, and after the thyristor is turned on, enough energy can be obtained to ensure the normal conduction of the thyristor.

8. The bypass thyristor valve group inspection control apparatus according to claim 7, wherein the bypass thyristor valve group comprises only one bridge arm which is formed by connecting a plurality of thyristors in series, and comprises a corresponding control protection circuit; and the bypass thyristor valve group is configured to bypass a voltage source converter (1) connected in parallel thereto or a voltage source converter on a parallel branch thereof.

9. The bypass thyristor valve group inspection control apparatus according to claim 7, wherein the principle of dividing the bypass thyristor valve group into N sub-modules is: when a single sub-module is turned on, the remaining sub-modules which are not turned on can bear a forward voltage during normal operation.

10. The bypass thyristor valve group inspection control apparatus according to claim 7, wherein the sequentially sending a control pulse to the valve-based electronic units of different sub-modules of the bypass thyristor valve group according to a certain time period refers to: triggering the sub-modules in sequence or triggering the sub-modules according to a certain probability algorithm, and ensuring that each sub-module is triggered at least once in the certain time period, wherein the certain time period is on the order of second, or minute, or hour, or day, or month, or year.

11. The bypass thyristor valve group inspection control apparatus according to claim 7, wherein the fact that the valve group control unit receives the sub-module turn-on signal of the valve-based electronic unit is that all thyristors in the sub-modules are turned on, or a certain redundancy is set for the sub-modules, and the thyristors that do not exceed the redundancy in the sub-modules are turned on; and the fact that the valve group control unit does not receive the sub-module turn-on signal of the valve-based electronic unit is that any one or more thyristors in the sub-modules are not turned on, or the thyristors that exceed the redundancy in the sub-modules are not turned on.

12. The bypass thyristor valve group inspection control apparatus according to claim 7, wherein the thyristor turn-on signal sent to the valve-based electronic unit by the thyristor
control unit means that the thyristor-born forward voltage signal disappears, or current flows through the thyristor, or the thyristor-born forward voltage signal reappears.

13. The bypass thyristor valve group inspection control apparatus according to claim 7, wherein the control circuit of the thyristor control unit has a protective trigger function, and if the thyristor does not receive the trigger pulse of the valve-based electronic unit, before being broken down, the thyristor is subjected to protective trigger.

## Patentansprüche

1. Inspektionsverfahren für eine Bypassthyristorventilgruppe (2) zum Inspizieren von Untermodulen in einer Bypassthyristorventilgruppe, mit:
Unterteilen der Bypassthyristorventilgruppe in N Untermodule durch eine Ventilgruppesteuerungseinheit (14), wobei N größer oder gleich 2 ist, N eine natürliche Zahl ist und jedes Untermodul durch einen Thyristor oder durch Reihenschaltung von zwei oder mehr Thyristoren gebildet ist;
unter der Bedingung, dass an der Bypassthyristorventilgruppe beim normalen Betrieb eine Durchlassspannung anliegt, sequentielles Triggern der Untermodule gemäß einer gewissen Zeitdauer in Verbindung mit einer Ventil-basierten Elektronikeinheit (15); und
Erfassen, ob die Untermodule in der Lage sind, normal zu arbeiten oder nicht, und falls nicht, Senden eines Alarmsignals,
wobei die Bypassthyristorventilgruppe ferner eine Thyristorsteuerungseinheit (16) aufweist und das Inspektionsverfahren ferner umfasst:
Empfangen eines Triggerpulses der Ventil-basierten Elektronikeinheit in der Thyristorsteuerungseinheit;
Senden des am Thyristor anliegenden Durchlassspannungssignals an die Ventil-basierte Elektronikeinheit mittels der Thyristorsteuerungseinheit; und
Senden des Thyristoreinschaltsignals an die Ventil-basierte Elektronikeinheit mittels der Thyristorsteuerungseinheit, wobei die Thyristorsteuerungseinheit ferner eine Leistungsschleife (18) und eine Widerstands-Kapazitäts-Entladeschleife (19) aufweist; wobei die Leistungsschleife zumindest zwei statische Widerstände mit gemeinsamer Spannung und einen Energiespeicherkondensator aufweist, und vor dem Einschalten des Thyristors ausreichend Energie erhalten werden kann, um das normale Einschalten des Thyristors zu gewährleisten; und die Widerstands-Kapazitäts-Entladeschleife zumindest einen Widerstand und einen Kondensator, die in Reihe geschaltet sind, aufweist, und nach dem Einschalten des Thyristors ausreichend Energie erhalten werden kann, um das normale Leiten des Thyristors zu gewährleisten.

2. Inspektionsverfahren für eine Bypassthyristorventilgruppe nach Anspruch 1, wobei die Bypassthyristorventilgruppe nur einen einzigen Brückenarm, der durch Reihenschaltung mehrerer Thyristoren gebildet ist, und eine entsprechende Steuerungsschutzschaltung aufweist;
und wobei die Bypassthyristorventilgruppe ausgebildet ist, einen Spannungsquellenwandler (1), der parallel geschaltet ist, oder einen Spannungsquellenwandler in einem parallelen Zweig zu umgehen.

3. Inspektionsverfahren für eine Bypassthyristorventilgruppe nach Anspruch 1, wobei das Prinzip des Unterteilens der Bypassthyristorventilgruppe in N Untermodule darin besteht: wenn ein einzelnes Untermodul eingeschaltet wird, nehmen die verbleibenden Untermodule, die nicht eingeschaltet sind, im normalen Betrieb die Durchlassspannung auf.

4. Inspektionsverfahren für eine Bypassthyristorventilgruppe nach Anspruch 1, wobei das sequentielle Triggern der Untermodule gemäß einer gewissen Zeitdauer bezeichnet: Triggern der Untermodule der Reihe nach oder Triggern der Untermodule gemäß einem gewissen Wahrscheinlichkeitsalgorithmus, und Sicherstellen, dass jedes Untermodul mindestens einmal in der gewissen Zeitdauer getriggert wird, wobei eine gewisse Zeitdauer in der Größenordnung einer Sekunde, oder einer Minute, oder einer Stunde, oder eines Tages, oder eines Monats, oder eines Jahres liegt.

5. Inspektionsverfahren für eine Bypassthyristorventilgruppe nach Anspruch 1, wobei Erfassen, ob die Untermodule in der Lage sind, normal zu arbeiten oder nicht, auf der Grundlage davon ermittelt wird, ob erfasst wird, ob die Untermodule in einem Übergang von ausgeschaltet zu eingeschaltet, oder in einem eingeschalteten Zustand, oder in einem Übergang von eingeschaltet zu ausgeschaltet sind.

6. Inspektionsverfahren für eine Bypassthyristorventilgruppe nach Anspruch 1, wobei der normale Betrieb der Untermodule bedeutet, dass alle Thyristoren in den Untermodulen normal eingeschaltet werden können, oder eine gewisse Redundanz für die Untermodule festgelegt ist; wenn erkannt wird, dass die Anzahl an Thyristoren, die in den Untermodulen nicht eingeschaltet werden können, kleiner als die Redundanz ist, die Inspektion fortgesetzt wird; und wenn die Bypassthyristorventilgruppe in Betrieb gesetzt werden soll, die Thyristoren, die nicht eingeschaltet werden können, einen Stromfluss mittels eines Schutztriggers oder Durchschlags ermöglichen.

7. Inspektionssteuerungsvorrichtung für eine Bypassthyristorventilgruppe (2) zum Inspizieren von Untermodulen in einer Bypassthyristorventilgruppe, mit einer Ventilgruppensteuerungseinheit (14), einer Ventil-basierten Elektronikeinheit (15) und einer Thyristorsteuerungseinheit (16), wobei
die Ventilgruppensteuerungseinheit ausgebildet ist zum: Unterteilen der Bypassthyristorventilgruppe in N Untermodule, wobei N größer oder gleich 2 ist, N eine natürliche Zahl ist, und jedes Untermodul durch einen Thyristor oder durch Reihenschaltung von zwei oder mehr Thyristoren gebildet ist; Erfassen einer Durchlassspannung, die an der Bypassthyristorventilgruppe während des normalen Betriebs anliegt; sequentielles Senden eines Steuerpulses an die Ventil-basierten Elektronikeinheiten verschiedener Untermodule der Bypassthyristorventilgruppe gemäß einer gewissen Zeitdauer; Empfangen von Untermoduleinschaltsignalen der Ventil-basierten Elektronikeinheiten; und wenn kein Untermoduleinschaltsignal der Ventil-basierten Elektronikeinheiten empfangen wird, Senden eines Alarmsignals;
wobei die Ventil-basierte Elektronikeinheit ausgebildet ist, den Steuerpuls der Ventilgruppensteuerungseinheit und ein am Thyristor anliegendes Durchlassspannungssignal der Thyristorsteuerungseinheit zu empfangen, ein Thyristoreinschaltsignal der Thyristorsteuerungseinheit zu empfangen, einen Triggerpuls an die Thyristorsteuerungseinheit zu senden, und das Untermoduleinschaltsignal an die Ventilgruppensteuerungseinheit zu senden; und
wobei die Thyristorsteuerungseinheit eine Steuerschaltung (17) aufweist, die ausgebildet ist, den Triggerpuls der Ventil-basierten Elektronikeinheit zu empfangen, das am Thyristor anliegende Durchlassspannungssignal an die Ventil-basierte Elektronikeinheit zu senden, und das Thyristoreinschaltsignal an die Ventil-basierte Elektronikeinheit zu senden, wobei die Thyristorsteuerungseinheit ferner eine Leistungsschleife (18) und eine Widerstands-Kapazitäts-Entladeschleife (19) aufweist, wobei die Leistungsschleife zumindest zwei statische Widerstände mit gemeinsamer Spannung und einen Energiespeicherkondensator aufweist, und vor dem Einschalten des Thyristors ausreichend Energie erhalten werden kann, um das normale Einschalten des Thyristors zu gewährleisten, und die Widerstands-Kapazitäts-Entladeschleife zumindest einen Widerstand und einen Kondensator, die in Reihe geschaltet sind, aufweist, und nach dem Einschalten des Thyristors ausreichend Energie erhalten werden kann, um das normale Leiten des Thyristors zu gewährleisten.

8. Inspektionssteuerungsvorrichtung für eine Bypassthyristorventilgruppe nach Anspruch 7, wobei die Bypassthyristorventilgruppe nur einen Brückenarm, der durch Reihenschaltung mehrerer Thyristoren gebildet ist, und eine entsprechende Steuerungsschutzschaltung aufweist; und die Bypassthyristorventilgruppe ausgebildet ist, einen Spannungsquellenwandler (1), der dazu parallel geschaltet ist, oder einen Spannungsquellenwandler in einem parallelen Zweig dazu, zu umgehen.

9. Inspektionssteuerungsvorrichtung für eine Bypassthyristorventilgruppe nach Anspruch 7, wobei das Prinzip des Unterteilens der Bypassthyristorventilgruppe in N Untermodule darin besteht: wenn ein einzelnes Untermodul eingeschaltet ist, können die verbleibenden Untermodule, die nicht eingeschaltet sind, während des normalen Betriebs eine Durchlassspannung führen.

10. Inspektionssteuerungsvorrichtung für eine Bypassthyristorventilgruppe nach Anspruch 7, wobei das sequentielle Senden eines Steuerpulses an die Ventil-basierten Elektronikeinheiten der unterschiedlichen Untermodule der Bypassthyristorventilgruppe gemäß einer gewissen Zeitdauer bezeichnet: Triggern der Untermodule der Reihe nach oder Triggern der Untermodule gemäß einem gewissen Wahrscheinlichkeitsalgorithmus, und Sicherstellen, dass jedes Untermodul mindestens einmal in der gewissen Zeitdauer getriggert wird, wobei die gewisse Zeitdauer in der Größenordnung einer Sekunde, oder einer Minute, oder einer Stunde, oder eines Tages, oder eines Monats, oder eines Jahres liegt.

11. Inspektionssteuerungsvorrichtung für eine Bypassthyristorventilgruppe nach Anspruch 7, wobei die Tatsache, dass die Ventilgruppensteuerungseinheit das Untermoduleinschaltsignal der Ventil-basierten Elektronikeinheit empfängt, darin besteht, dass alle Thyristoren in den Untermodulen eingeschaltet werden, oder eine gewisse Redundanz für die Untermodule festgelegt ist, und die Thyristoren, die die Redundanz in den Untermodulen nicht übersteigen, eingeschaltet sind; und die Tatsache, dass die Ventilgruppensteuerungseinheit das Untermoduleinschaltsignal der Ventil-basierten Elektronikeinheit nicht empfängt, darin besteht, dass einer oder mehrere Thyristoren in den Untermodulen nicht eingeschaltet sind, oder die Thyristoren, die die Redundanz in den Untermodulen überschreiten, nicht eingeschaltet sind.

12. Inspektions- und Steuerungsvorrichtung für eine Bypassthyristorventilgruppe nach Anspruch 7, wobei das Thyristoreinschaltsignal, das von der Thyristorsteuerungseinheit an die Ventil-basierte Elektronikeinheit gesendet wird, bedeutet, dass das am Thyristor anliegende Durchlassspannungssignal verschwindet, oder Strom durch den Thyristor fließt, oder das am Thyristor anliegende Durchlassspannungssignal erneut auftritt.

13. Inspektionssteuerungsvorrichtung für eine Bypassthyristorventilgruppe nach Anspruch 7, wobei die Steuerschaltung der Thyristorsteuerungseinheit eine Schutztriggerfunktion aufweist, und falls der Thyristor ein Triggerpuls der Ventil-basierten Elektronikeinheit nicht empfängt, am den Thyristor der Schutztrigger angelegt wird, bevor ein Durchschlag erfolgt.

## Revendications

1. Procédé d'inspection d'un groupe de valves à thyristors de dérivation (2) pour inspecter des sous-modules dans un groupe de valves à thyristors de dérivation, comprenant les étapes consistant à :
diviser, par une unité de commande de groupe de valves (14), le groupe de valves à thyristors de dérivation en N sous-modules, dans lequel N est supérieur ou égal à 2, N est un nombre naturel, et chaque sous-module est formé par un thyristor ou en connectant deux thyristors ou plus en série ;
à condition que le groupe de valves à thyristors de dérivation supporte une tension directe pendant un fonctionnement normal, déclencher séquentiellement, en association avec une unité électronique basé sur une valve (15), les sous-modules selon une certaine période de temps ; et
détecter si les sous-modules sont capables de fonctionner normalement ou non, et si ce n'est pas le cas, envoyer un signal d'alarme,
dans lequel le groupe de valves à thyristors de dérivation comprend en outre une unité de commande de thyristors (16), et le procédé d'inspection comprend en outre les étapes consistant à :
recevoir, par l'unité commande de thyristors, une impulsion de déclenchement de l'unité électronique basée sur une valve ;
envoyer, par l'unité de commande de thyristors, le signal de tension directe issu de thyristors à l'unité électronique basée sur une valve ; et
envoyer, par l'unité de commande de thyristors, le signal de mise sous tension de thyristors à l'unité électronique basée sur valve, dans lequel l'unité de commande de thyristors comprend en outre une boucle d'alimentation (18) et une boucle de décharge à résistance-capacité (19) ; la boucle d'alimentation comprend au moins deux résistances de partage de tension statique et un condensateur de stockage d'énergie, et avant la mise sous tension du thyristor, suffisamment d'énergie peut être obtenue pour assurer la mise sous tension normale du thyristor ; et la boucle de décharge à résistance-capacité comprend au moins une résistance et un condensateur qui sont connectés en série, et après la mise sous tension du thyristor, suffisamment d'énergie peut être obtenue pour assurer la conduction normale du thyristor.

2. Procédé d'inspection de groupe de valves à thyristors de dérivation selon la revendication 1, dans lequel le groupe de valves à thyristors de dérivation comprend un seul bras de pont qui est formé en connectant une pluralité de thyristors en série, et comprend un circuit de protection de commande correspondant ; et le groupe de valves à thyristors de dérivation est configuré pour contourner un convertisseur de source de tension (1) connecté en parallèle à celui-ci ou un convertisseur de source de tension sur une branche parallèle de celui-ci.

3. Procédé d'inspection de groupe de valves à thyristors de dérivation selon la revendication 1, dans lequel le principe de division du groupe de valves à thyristors de dérivation en N sous-modules est le suivant : lorsqu'un sous-module unique est mis sous tension, les sous-modules restants qui ne sont pas mis sous tension peuvent supporter la tension directe pendant un fonctionnement normal.

4. Procédé d'inspection de groupe de valves à thyristors de dérivation selon la revendication 1, dans lequel le déclenchement séquentiel des sous-modules selon une certaine période de temps fait référence : au déclenchement des sous-modules en séquence ou au déclenchement des sous-modules selon un certain algorithme de probabilité, et à la garantie que chaque sous-module est déclenché au moins une fois au cours de la certaine période de temps, la certaine période de temps étant de l'ordre d'une seconde, ou d'une minute, ou d'une heure, ou d'un jour, ou d'un mois, ou d'une année.

5. Procédé d'inspection de groupe de valves à thyristors de dérivation selon la revendication 1, dans lequel la détection si les sous-modules sont capables de fonctionner normalement ou non est déterminée sur la base de la détection si les sous-modules passent d'un état bloqué à un état passant, ou sont dans un état passant, ou passent d'un état passant à un état bloqué.

6. Procédé d'inspection de groupe de valves à thyristors de dérivation selon la revendication 1, dans lequel le fonctionnement normal des sous-modules signifie que tous les thyristors des sous-modules peuvent être normalement mis sous tension, ou qu'une certaine redondance est définie pour les sous-modules ; s'il est détecté que le nombre de thyristors qui ne peuvent pas être mis sous tension dans les sous-modules est inférieur à la redondance, l'inspection se poursuit ; et si le groupe de valves à thyristors de dérivation doit être mis en service, les thyristors qui ne peuvent pas être mis sous tension fournissent un flux de courant au moyen d'un déclenchement ou d'une coupure de protection.

7. Appareil de commande d'inspection de groupe de valves à thyristors de dérivation (2) pour inspecter des sous-modules dans un groupe de valves à thyristors de dérivation, comprenant une unité de commande de groupe de valves (14), une unité électronique basée sur une valve (15), et une unité de commande de thyristors (16), dans lequel
l'unité de commande de groupe de valves est configurée pour : diviser le groupe de valves à thyristors de dérivation en N sous-modules, dans lequel N est supérieur ou égal à 2, N est un nombre naturel, et chaque sous-module est formé par un thyristor ou en connectant deux thyristors ou plus en série ; détecter une tension directe issue du groupe de valves à thyristors de dérivation pendant un fonctionnement normal ; envoyer séquentiellement une impulsion de commande aux unités électroniques basées sur une valve de différents sous-modules du groupe de valves à thyristors de dérivation selon une certaine période de temps ; recevoir des signaux de mise sous tension de sous-module des unités électroniques basées sur une valve ; et si aucun signal de mise sous tension de sous-module des unités électroniques basées sur une valve n'est reçu, envoyer un signal d'alarme ;
l'unité électronique basée sur une valve est configurée pour recevoir l'impulsion de commande de l'unité de commande de groupe de valves et un signal de tension directe issu de thyristor de l'unité de commande de thyristors, recevoir un signal de mis sous tension de thyristors de l'unité de commande de thyristors, envoyer une impulsion de déclenchement à l'unité de commande de thyristors, et envoyer le signal de mise sous tension de sous-module à l'unité de commande de groupe de valves ; et
l'unité de commande de thyristors comprend un circuit de commande (17), configuré pour recevoir l'impulsion de déclenchement de l'unité électronique basée sur une valve, envoyer le signal de tension directe issu de thyristor à l'unité électronique basée sur une valve, et envoyer le signal de mise sous tension de thyristor à l'unité électronique basée sur une valve, dans lequel l'unité de commande de thyristor comprend en outre une boucle d'alimentation (18) et une boucle de décharge à résistance-capacité (19), la boucle d'alimentation comprend au moins deux résistances de partage de tension statique et un condensateur de stockage d'énergie, et avant la mise sous tension du thyristor, suffisamment d'énergie peut être obtenue pour assurer la mise sous tension normale du thyristor, et la boucle de décharge à résistance-capacité comprend au moins une résistance et un condensateur qui sont connectés en série, et après la mise sous tension du thyristor, suffisamment d'énergie peut être obtenue pour assurer la conduction normale du thyristor.

8. Appareil de commande d'inspection de groupe de valves à thyristors de dérivation selon la revendication 7, dans lequel le groupe de valves à thyristors de dérivation comprend uniquement un bras de pont qui est formé en connectant une pluralité de thyristors en série, et comprend un circuit de protection de commande correspondant ; et le groupe de valves à thyristors de dérivation est configuré pour contourner un convertisseur de source de tension (1) connecté en parallèle à celui-ci ou un convertisseur de source de tension sur une branche parallèle de celui-ci.

9. Appareil de commande d'inspection de groupe de valves à thyristors de dérivation selon la revendication 7, dans lequel le principe de division du groupe de valves à thyristors de dérivation en N sous-modules est le suivant : lorsqu'un sous-module unique est mis sous tension, les sous-modules restants qui ne sont pas mis sous tension peuvent supporter une tension directe pendant un fonctionnement normal.

10. Appareil de commande d'inspection de groupe de valves à thyristors de dérivation selon la revendication 7, dans lequel l'envoi séquentiel d'une impulsion de commande aux unités électroniques basées sur une valve de différents sous-modules du groupe de valves à thyristors de dérivation selon une certaine période de temps fait référence : au déclenchement des sous-modules en séquence ou au déclenchement des sous-modules selon une certain algorithme de probabilité, et à la garantie que chaque sous-module est déclenché au moins une fois au cours de la certaine période de temps, la certaine période de temps étant de l'ordre d'une seconde, ou d'une minute, ou d'une heure, ou d'un jour, ou d'un mois, ou d'une année.

11. Appareil de commande d'inspection de groupe de valves à thyristors de dérivation selon la revendication 7, dans lequel le fait que l'unité de commande de groupe de valves reçoive le signal de mise sous tension de sous-module de l'unité électronique basée sur une valve signifie que tous les thyristors dans les sous-modules sont mis sous tension, ou qu'une certaine redondance est définie pour les sous-modules, et les thyristors qui ne dépassent pas la redondance dans les sous-modules sont mis sous tension ; et le fait que l'unité de commande de groupe de valves ne reçoit pas le signal de mise sous tension de sous-module de l'unité électronique basée sur une valve signifie qu'un quelconque ou plusieurs thyristors dans les sous-modules ne sont pas mis sous tension, ou que les thyristors qui dépassent le la redondance dans les sous-modules ne sont pas mis sous tension.

12. Appareil de commande d'inspection de groupe de valves à thyristors de dérivation selon la revendication 7, dans lequel le signal de mise sous tension de thyristor envoyé à l'unité électronique basée sur une valve par l'unité de commande de thyristors signifie que le signal de tension directe issu de thyristor disparaît, ou qu'un courant circule à travers le thyristor, ou que le signal de tension directe issu de thyristor réapparaît.

13. Appareil de commande d'inspection de groupe de valves à thyristors de dérivation selon la revendication 7, dans lequel le circuit de commande de l'unité de commande de thyristors a une fonction de déclenchement de protection, et si le thyristor ne reçoit pas l'impulsion de déclenchement de l'unité électronique basée sur une valve, avant d'être coupé, le thyristor est soumis à un déclenchement de protection.
